(19) Europäisches Patentamt
European Patent Office
Office européen des brevets

(11) **EP 1 505 732 B1**

(12) **EUROPEAN PATENT SPECIFICATION**

(45) Date of publication and mention of the grant of the patent:
**26.09.2007 Bulletin 2007/39**

(51) Int Cl.:
*H03K 7/06* *(2006.01)*       *H03K 7/04* *(2006.01)*

(21) Application number: **04103610.4**

(22) Date of filing: **28.07.2004**

(54) **Digital clock modulator**

Digitaler Taktmodulator

Modulateur numérique d'horloge

(84) Designated Contracting States:
**DE FR GB IT**

(30) Priority: **31.07.2003 IN DE09492003**

(43) Date of publication of application:
**09.02.2005 Bulletin 2005/06**

(73) Proprietor: **STMicroelectronics Pvt. Ltd
Noida 201 301,
Uttar Pradesh (IN)**

(72) Inventor: **NANDY, Tapas
110 096, Delhi (IN)**

(74) Representative: **Maccalli, Marco et al
Maccalli & Pezzoli S.r.l.,
Via Settembrini, 40
20124 Milano (IT)**

(56) References cited:
**US-A- 5 699 005       US-A- 5 796 673
US-B1- 6 518 813**

## Description

### Field of the Invention

The invention relates to an improved digital clock modulator providing a smoothly modulated clock period to reduce amplitude of Electro-Magnetic Radiations (EMR) emitted during clock transitions.

### Background of the Invention

The Electro-Magnetic Radiations (EMR) emitted by higher harmonics of the basic clock frequency of a digital circuit due to the activities at the clock edges significantly effect the normal operation of neighboring circuits. In order to prevent the adverse effects of such EMR it is desired that the amplitude of the emitted radiations is kept to the minimum. Various methods have been adopted for reducing the amplitude of interfering radiations. For example the phase / frequency of basic clock frequency is modulated for spreading the emitted radiation frequency band for distributing the radiating energy into adjacent side-bands about each harmonic frequency, consequently reducing the amplitude of higher harmonic frequencies.

Frequency modulation, predominantly, is an analog technique and has overheads in implementations in the Integrated Circuit (IC). Moreover any arbitrary modulation does not generate an optimum EMI reduction; in other words, randomly modulating a clock generating source may not provide improved attenuation of EMI. A proper selection of the modulation is essential to ensure its effectiveness in reducing EMR. ['Spread Spectrum Clock Generation for the Reduction of Radiated Emissions': Keith B. Hardin et al, IEEE International Symposium on Electromagnetic Compatibility, 22-26 Aug, 1994]

US patents US6366174, US6373306, US6351485B1 propose the use of PLLs for reducing EMR. These techniques cannot however be used for systems in which the PLL is a procured object, which cannot be modified.

Some prior art digital modulation of the clock period, for example, US patent US5442664 proposes the use of 'n' number of delay components, of equal delay $\Delta$, as shown in Figure-1. Selection control **3** (up/down counter of n-states), uses delay tap selection logic **2** to modulate the time period of the clock. It makes the clock period $(T_{ck}+ \Delta)$ for the first 'n' clock cycles and $(T_{ck}- \Delta)$ for the next 'n' clock cycles, alternating in this manner continuously. This technique does not provide optimum spread spectrum EMR reduction as the energy concentrates around two frequencies $1/(T_{ck}+\Delta)$ and $1/(T_{ck}-\Delta)$ only.

US patent US 6518813 discloses a similar circuit.

US2001045857 proposes a similar scheme, differing only in that it provides a technique to adjust $(\Delta/T_{ck})$. By adjusting the supply voltage to the delay units. This technique is not suitable for most integrated digital systems as it calls for varying the supply voltage.

US patent US5699005 proposes a technique utilizing both equal delay and unequal delays in the delay chain block, but effectively the successive increment (decrement) of the delay in the delay chain are always constant ($\Delta$). The main difference lies in the way the switching the delay taps onto clock output is performed. Here, the delay tap selection is done using a Pseudo-random number sequence, which causes radiation energy spectrum to be better distributed compared to the previous techniques, However, the "pseudorandom" nature results in sharp odd time period variation while others time periods are very slow, resulting in the concentration of the radiated frequency around certain frequencies instead of spreading as evenly as possible.

### Summary of the Invention:

The object of this invention is to obviate the above drawbacks of the present art with respect to even distribution of the radiated emissions in digital clock circuits.

Another object of the invention is to provide a technique for the smooth digital modulation of clock periods.

It is yet another object of the invention to provide a finely distributed clock energy spectrum for reducing the amplitude of the EMR, with smaller peak to peak variation of the clock period (i.e., smaller modulation index) over large number of clock cycles (i.e., slower modulating frequency).

It is a further object of the invention to provide a flexibile design capable of producing any desired clock-period modulating pattern (i.e., modulating waveform).

To achieve above and other objects of the invention the present invention provides an improved digital clock modulator providing a smoothly modulated clock period to reduce emitted Electro-Magnetic Radiation (EMR) comprising:

- a plurality of delay elements connected in series receiving an unmodulated clock signal at the input;
- a multiplexer receiving inputs from unequally spaced selected taps provided between said delay elements;
- a control block supplying the selection-inputs to said multiplexer, and receiving a clock signal from said series of delay elements; and

- a predetermined delay element connected between the clock terminal of said control block and the last element of said series of delay elements for enabling glitch free operation by ensuring that the entire delay chain and related signal paths are in the same stable state before the control to the multiplexer changes.

The said taps are provided in accordance with the modulation of the clock period.

The said control block includes an up/down counting means for sequentially selecting the taps in the delay chain so that the difference in delays of input to output clock increases consecutively for consecutive clock cycles for one half of the modulating period and then reduces in a similar manner for the second half of the modulating period;

The taps are spaced further apart from each other in the middle of the clock chain are spaced closer together at the two ends of the chain.

The invention further includes a delay interpolation mechanism for providing a finer resolution of clock modulation over a larger number of clock cycles.

The invention with the delay interpolation mechanism comprises:

- a pair of multiplexers replacing the single multiplexer with alternate taps of the delay chain connected to each multiplexer;
- chain of series connected PMOS-NMOS transistors pairs that are sized such that their channel-length-to-channel-width ratios increase in a binary weighted sequence, connected to the output of each multiplexer. and
- control circuit that generates complementary control signals for enabling the series connected PMOS-NMOS transistor pairs in a desired sequence.

The code for multiplexer selection is a monotonically increasing code for increasing clock modulation depth, whereas the code for delay interpolation increases or decreases for alternate codes for the multiplexer.

The modulating wave form is selected by sequencing the delay selection code and the delay interpolator code to provide consecutively increasing delays and difference in delays in the clock path for consecutive clock cycles over one half of modulating period followed by similarly decreasing delays and difference in delays for the second half of the modulating period.

The present invention further provides a method for reducing emitted Electro Magnetic Radiation (EMR) from digital clock circuits by smoothly modulating the clock period comprising the steps of:

- connecting a plurality of delay elements in series and supplying an unmodulated clock signal at the input of the first delay element;
- multiplexing selected outputs obtained from selected taps in the chain of delay elements; and
- delaying the clock to the last element of the delay chain suitably with respect to the multiplexing for enabling glitch free operation.

According to the method of present invention for reducing emitted Electro Magnetic Radiation (EMR) from digital circuits the taps for multiplexing are selected based on the desired modulating wave.

The method of the present invention for reducing emitted Electro Magnetic Radiation (EMR) from digital circuits, including selecting the consecutively increasing delays and difference in delays in the clock delay path in consecutive clock cycles upto a maximum allowed delay, for one half of the modulating wave's period, and then reducing the delays similarly for the second half of the modulating period.

A method for reducing emitted Electro Magnetic Radiation (EMR) from digital circuits further including suitably delaying the clock of said control block to ensure that the entire delay chain and other concerned signal paths are in the same stable logical state ('0' or '1') before the control to the multiplexer changes.

The said predetermined delay is determined for unmodulated clock cycle as

$$\sum u(i).\Delta \; + \; \mathbf{T}_{mux} \; + \; T_{del} \; + T_{CK \to Sel} \; < \; \mathbf{T}_{HLmin}$$

where,

$T_{mux}$ is the maximum input to output delay of the said multiplexer;

$T_{CK \to SEL}$ is the clock to output delay of the said control block;

$T_{HLmin}$ is the minimum of the high or low phase of the said un-modulated clock cycle;

$T_{del}$ is the delay to be provided,

$\Sigma u(i).\Delta$ is the total delay of the said series of delay elements.

A method for reducing emitted Electro Magnetic Radiation (EMR) from digital circuits further including a method for delay interpolation for providing a finer resolution of clock modulation.

A method for reducing emitted Electro Magnetic Radiation (EMR) from digital circuits wherein the method for delay interpolation comprises the steps of:

- multiplexing alternate taps of the delay chain separately to;
- connecting a chain of series PMOS-NMOS transistors pairs that are sized such that their channel-length-to-channel-width ratios increase in a binary weighted sequence, and;
- generating complementary control signals for enabling the series connected PMOS-NMOS transistor pairs in a desired sequence.
  A method for reducing emitted Electro Magnetic Radiation (EMR) from digital circuits by monotonically increasing the code for multiplexer selection for increasing clock modulation depth and increasing or decreasing the code for delay interpolation for alternate codes for the multiplexer.

**Brief Description of the Accompanying Drawings:**

The invention will now be described with reference to the accompanying drawings

**Figure 1:** shows a digital clock period modulator in accordance with prior art similar to US 5442664.

**Figure 2:** shows arbitrary time functions and their representation in frequency domain.

**Figure 3:** shows a system time period modulation over one modulating period $T_M$,

**Figure 4:** shows a Plot of function Z'(x) for p=1%, n = 16 and u(i) = i.

**Figure 5:** shows a Plot of function Z'(x) for p=2.5%, n = 16 and u(i) = i.

**Figure 6:** shows a Plot of function Z'(x) for p=1 %, n = 32 and u(i) = i.

**Figure 7:** shows a Plot of function Z'(x) for p=2.5%, n = 32 and u(i) = i.

**Figure 8:** shows a digital clock period modulator in accordance with the present invention.

**Figure 9:** shows one possible plot of time period variation.

**Figure 10:** shows graph for the delay distribution of the present invention.

**Figure 11:** shows another possible embodiment of the invention incorporating finer modulation of the clock period.

**Figure 12:** shows a graph corresponding to a second embodiment of the invention for generating control signal and time period modulation.

**Detailed Description:**

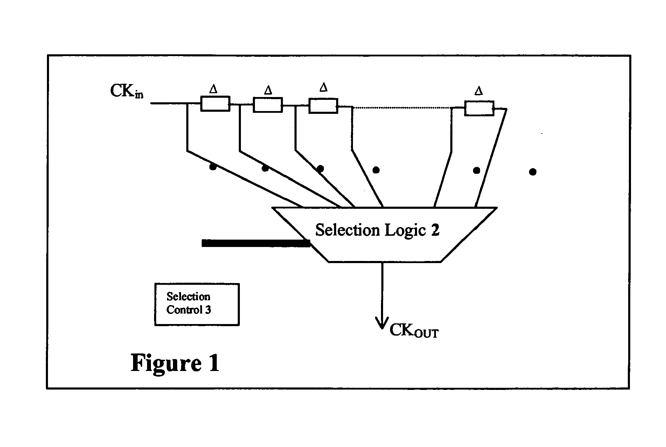

**Figure 1** has already been discussed under the heading 'Background to the Invention'.
The circuit of the present invention is the manifestation of the following mathematical analysis.

*Time Period modulation and its spectral representation:*

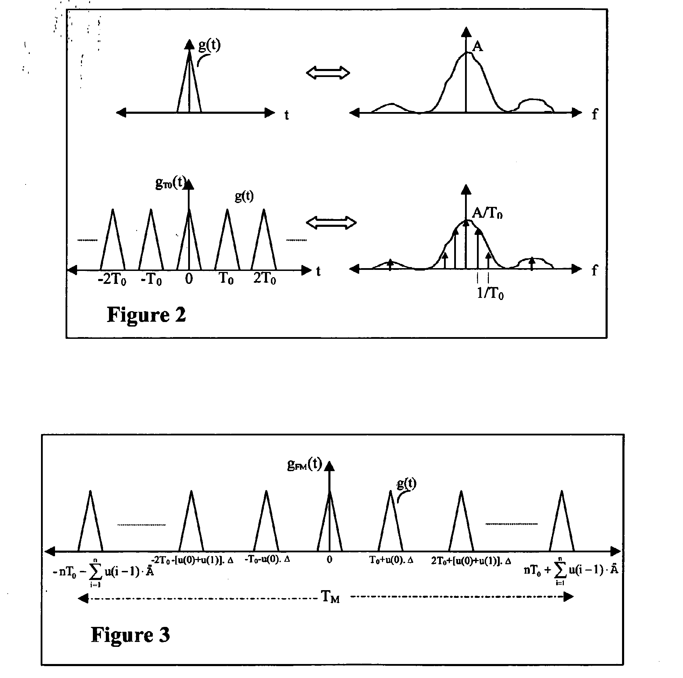

An arbitrary time dependent signal g(t) occurring in the time period $T_0$ can be represented in the frequency domain by its Fourier transform G(*f*); it can be switching current spikes, for example. The **figure 2** shows such an arbitrary time dependent signal g(t) and its frequency domain representation G(*f*).
The Fourier Transform is given by equation (1) :

$$g(t) \Leftrightarrow G(f) \qquad\qquad \dots\dots\dots\dots\dots (1)$$

If g(t) repeats every $T_0$, as shown in **figure 2** $g_{T0}(t)$, in frequency domain it would be represented by the equation (2):

$$g_{T0}(t) \Leftrightarrow \frac{1}{T_0} \cdot \sum_{m=-\infty}^{+\infty} G\left(\tfrac{m}{T_0}\right) \cdot \delta\left(f - \tfrac{m}{T_0}\right) \qquad \dots\dots\dots\dots(2)$$

where, the Dirac deltas, $\delta\left(f - \tfrac{m}{T_0}\right)$, are the discrete frequency components in frequency domain occurring at harmonics of frequency ($1/T_0$). The amplitude gets scaled by $1/T_0$ over the same Fourier transform function, $G(f)$, of equation (1).

Consider a time dependent function which repeats over a varying time period ($T_0 + u(i) \cdot \Delta$) with a pattern repeating over a period $T_M$ as shown in **Figure 3.**

$T_M$ is the period of the modulating wave and u(i) is the effective modulating function on unmodulated time period, $T_0$. The period $T_M$ is given by equation (3) :

$$T_M = 2T_0 \cdot \left[ n + \sum_{i=1}^{n} u(i-1) \cdot \tfrac{\Delta}{T_0} \right] \qquad \dots\dots\dots\dots (3)$$

The Fourier Transform of the activity over one period of $T_M$, as shown in figure 3 is given by (after using the time shift property of the Fourier Transform):

$$g_{FM}(t) \Leftrightarrow G(f) \cdot \left[ 1 + \sum_{l=1}^{n} [\exp\left\{ -j2\pi f T_0 \left( l + \sum_{i=1}^{l} u(i-1) \cdot \tfrac{\Delta}{T_0} \right) \right\} + \exp\left\{ +j2\pi f T_0 \left( l + \sum_{i=1}^{l} u(i-1) \cdot \tfrac{\Delta}{T_0} \right) \right\}] \right]$$

$$\therefore \ g_{FM}(t) \Leftrightarrow G(f) \cdot \left[ 1 + \sum_{l=1}^{n} 2 \cdot \cos\left\{ 2\pi f T_0 \left( l + \sum_{i=1}^{l} u(i-1) \cdot \tfrac{\Delta}{T_0} \right) \right\} \right] \quad \dots\dots (4)$$

The function $g_{FM\_TM}(t)$, is actually a function $g_{FM}(t)$ repeating after every $T_M$ period. Applying equations (1) and (2) on (4) we get,

$$g_{FM\_T0}(t) \Leftrightarrow \frac{1}{T_M} \sum_{m=-\infty}^{\infty} \left( G(\tfrac{m}{T_M}) \cdot \left[ 1 + \sum_{l=1}^{n} 2 \cdot \cos\left\{ 2\pi (\tfrac{m}{T_M}) T_0 \left( l + \sum_{i=1}^{l} u(i-1) \cdot \tfrac{\Delta}{T_0} \right) \right\} \right] \bullet \delta(f - \tfrac{m}{T_M}) \right) \dots (5)$$

On comparing equation (2) and (5), it is seen that after the signal is frequency modulated, discrete frequency components occur at more closely space frequency intervals, $\delta(f - \tfrac{m}{T_M})$, (since $T_M > T_0$). providing a spread spectrum effect. It is also observed that a factor Z(f) scales the transform amplitude envelope, $G(f)/T_0$ of the unmodulated periodic activity. Z(f) can be written as :

$$Z(f) = \frac{T_0}{T_M}\left[1 + \sum_{l=1}^{n} 2 \cdot \cos\left\{2\pi \cdot (fT_0) \cdot \left(l + \sum_{i=1}^{l} u(i-1) \cdot \frac{\Delta}{T_0}\right)\right\}\right] \quad \dots (6)$$

Following transforms done to see the effect of frequency modulation (or time period modulation) with different parameters on system clock.

On substituting 'x' for '(fT_0)', which is the real number multiple (integral and fractional) of the fundamental frequency (1/T_0).

For $\Delta T_0$ the maximum allowed deviation of the time period $T_0$, which is set by the system requirements assuming 'p' is the allowed fractional deviation of $T_0$ by the system the following equations can be written in terms of system specified variables, p, modulating wave, u(i) and n:

$$x = fT_0; \quad p = \frac{\Delta T_0}{T_0} ; \quad \Delta T_0 = u(n-1) \cdot \Delta ; \quad \frac{\Delta}{T_0} = \frac{p}{u(n-1)} ;$$

$$\&\quad \frac{T_0}{T_M} = \frac{1}{2(n + \frac{p}{u(n-1)}\sum_{i=1}^{n} u(i-1))} \quad \dots (7)$$

Substituting equation (7) in (6) we get an envelope multiplying factor, Z'(x):

$$Z'(x) = \frac{1}{2(n + \frac{p}{u(n-1)}\sum_{i=1}^{n} u(i-1))}\left[1 + \sum_{l=1}^{n} 2 \cdot \cos\left\{2\pi \cdot x \cdot \left(l + \sum_{i=1}^{l} u(i-1) \cdot \frac{p}{u(n-1)}\right)\right\}\right] \quad \dots (8)$$

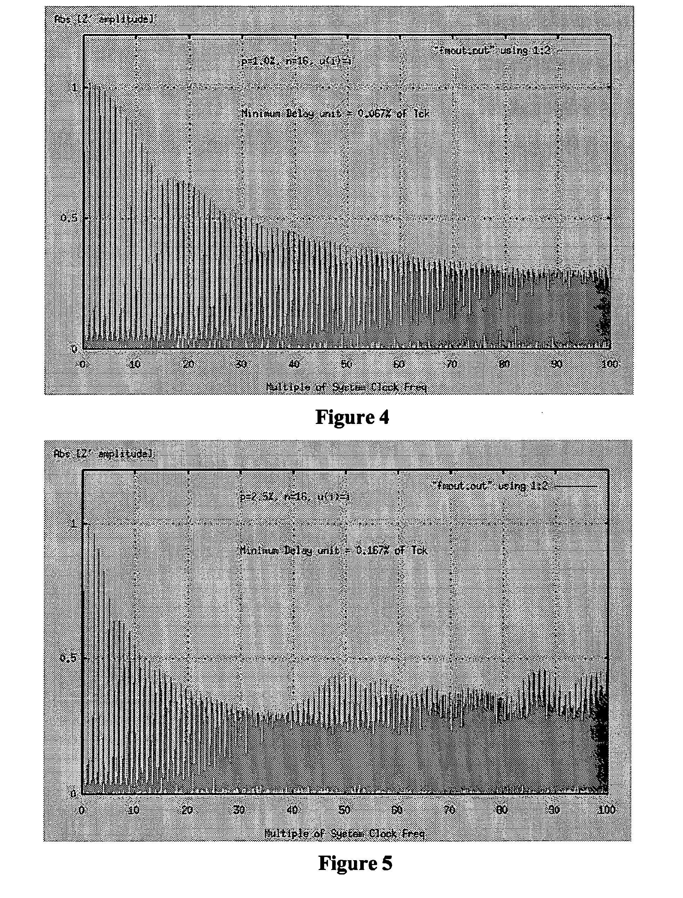

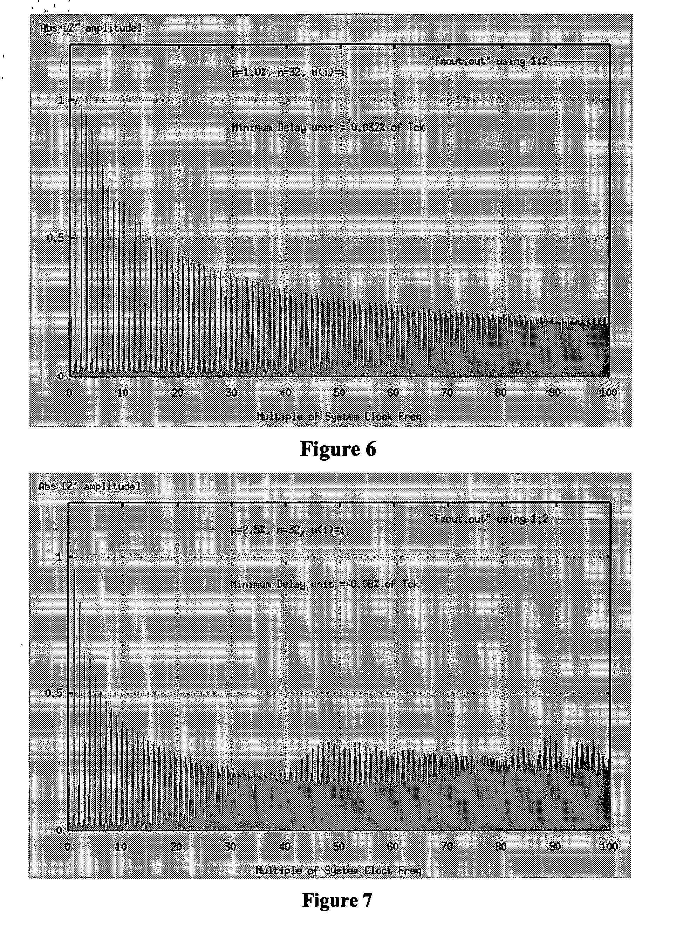

On plotting the function Z'(x), the scale factor for the radiation patterns, of equation (8) against values of 'p' and 'n'; keeping u(i) as a linear function, u(i) = i we get the graphs shown in **figures 4, 5, 6** and **7**. The graphs clearly show a substantial radiation attenuation of 6dB (the Y axis value of 0.5 or less) compared to the unmodulated system clock. It is also observed that larger values of 'p' (i.e., larger deviation of system clock period) for a given value of 'n' (same modulating frequency) give better attenuation. An attenuation of 6dB is achieved at the 30th harmonic of the signal for p=1% and n=16 as seen in **figure 4** whereas the same result is achieved at the 12th harmonic for p=2.5% as shown in **figure 5.** Similarly, a larger value of 'n' for a given value of 'p' provides better attenuation. An attenuation of 6dB is achieved at the 15th harmonic of the signal as shown in **figure 6** for p = 1% and n = 32 as compared to the case with n = 16 shown in **figure 4.** Further, for p = 2.5% and n = 32 an attenuation of 6 dB is achieved at the 6th harmonic of the signal. These observations are in agreement with frequency modulation theory [Communication Systems, by *Simon Haykin,* Wiley Eastern Limited, 1979]. It is to be noted that the attenuation at lower harmonics is very low, as is visible upto the 8th or 10th harmonic It is therefore necessary to know the frequency range for which the EMI is to be reduced before design.

*Circuit to realize time period modulation on the aforementioned principle:*

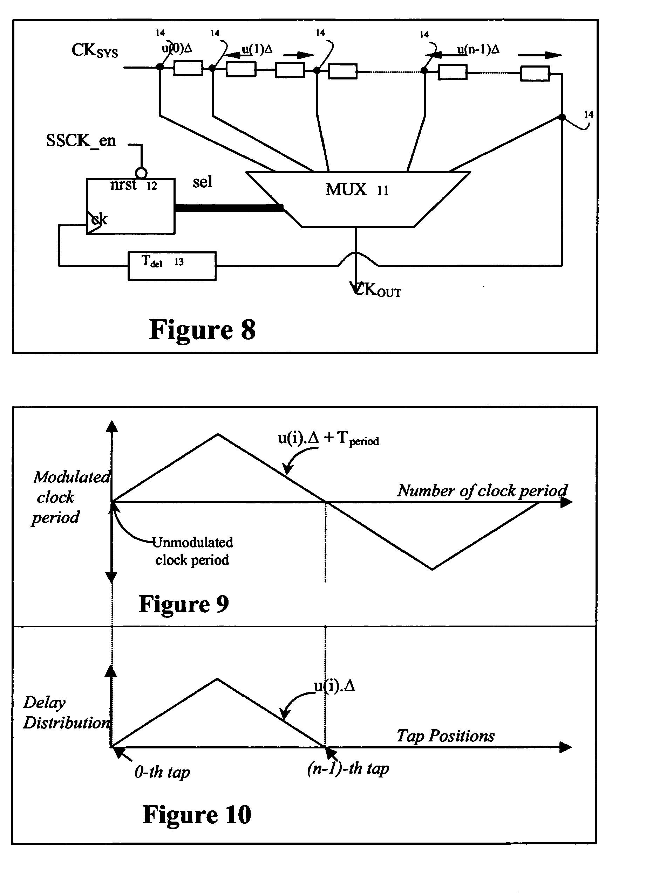

A preferred embodiment of the present invention is the circuit shown in **figure 8**. This embodiment has a delay line consisting of a chain of small delay elements, each of delay value $\Delta$, fed at the input by the system clock **CK_{in}.** The delay chain is tapped at different points **14** determined by the modulating wave's nature, as shown for example in **figure 9**. The delay segments distribution can be set to u(i) = i or any such function, not necessarily linear as shown. The delay steps preferably are maximum at the middle of the chain tapering off at the ends (shown as the delay distribution in **figure 10**) so as to provide a continuous curve modulating wave. The tapped delays are multiplexed at the output to produce a clock for the rest of the chip. The multiplexer **11** is implemented by transmission gates or tri-state gates. The control of the multiplexer comes from state machine **12** which counts up from 0 to 'n' states, followed by down counting from 'n' to '0' again. The lower half of the modulating wave in **figure 9** where the time period reduces from the unmodulated value, is achieved by the down counting of the state machine **12**.

Glitch free operation of the circuit is ensured by providing the clock input of the state machine **12** through a predetermined delay element **13** which receives its input from the output of the last element of the delay chain. The predetermined delay element is selected so that the when the multiplexer selects any input the entire delay chain to the state of the clock waveform (either logic '0' or '1'). When state machine changes, controls to the multiplexer **11** may not change at the same time, there may be a switching back and forth for some of the inputs to the out put before control settles; by this time all the inputs to the multiplexer have same settled value, output won't see any glitch. This is achieved by conforming to defined timing constraints. The value of the predetermined delay element **13** $T_{del}$ can be calculated pessimistically by the following relation:

$$\underbrace{\sum u(i).\Delta} + T_{mux} + T_{del} + T_{CK \to Sel} < T_{HLmin} \qquad \ldots\ldots\ldots\ (9)$$

Where, $T_{mux}$ is the maximum input to output delay in the multiplexer, $T_{CK>SEL}$ is the clock to output delay of the state-machine, $T_{HLmin}$ is the minimum of the high or low phase of the unmodulated system clock period and $\Sigma u(i).\Delta$ is the total delay of the delay chain.

The architecture can have an enable signal **SSCK_en,** for enabling/disabling the modulation.

The choice of 'u(i)', 'p' and 'n' of equation (8) depend on the minimum delay possible in the selected technology and the maximum deviation allowed in the system clock period. The delay element can consist of the minimum delay element available in the library or a finer delay element can be derived by available delay interpolation techniques. Quite often, larger variation ('p') of clock period is not allowed, so a modulating wave spanning over larger number of clock cycles ('n') would be preferred for better reduction of radiation, as it is evident from comparing **figure 4** vs. **6** or **figure 5** vs. **7**. In this case a much finer delay element would be necessary. Technique to achieve that is discussed in the second embodiment.

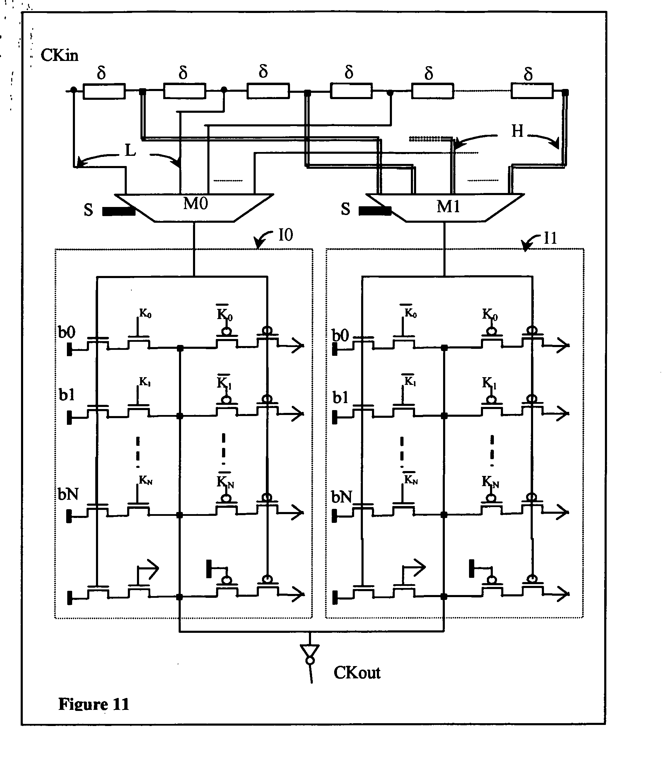

A second embodiment of the invention achieving finer delays than the library component by delay interpolation techniques is shown in **figure 11**. The delay elements $\delta$ are available delay units, Alternate taps (single line and double line taps) of the delay chain are fed to two multiplexer **M0** and **M1** which have the control signal-vector S. The outputs of the multiplexers are the inputs to the delay interpolation block **I0** and **I1** respectively. The interpolation blocks from a prior invention by STMicroelectronics [Roland Marbot, STMicroelectronics, US 6,169,436], and it is explained here just for the sake of clarity and completeness only **I0** and **I1** consist of branches **b0** to **bN** of series connected PMOS/NMOS transistors with binary weighted Width to Length (W/L) ratio(b0 having the smallest), alongwith the control signal to turn on the branches $K_0..K_N$, and their complements. The control signals $K_i$s and their complements are so connected to blocks **I0** and **I1,** that for the same control code, that for the same control code, if I0 section of the interpolator is stronger with more number of branches on, the I1 section will be weaker with less number of branches on and vice versa. This way, an interpolation of delay between $(i)\delta$ and $(i+1)\delta$ are achieved (refer to original patent document for details); and by interpolating delay between two taps (i.e., $\delta$) is divided into $2^N$ possible finer delays. However, after getting the finely spaced delays, the control code is generated [S and $K_i/K_i'$s ] sequentially (from a lower to a higher code and backward) so that the delay from CKin to CKout meets the requirements of the $u(i)\Delta$ function of a smooth modulating waveform.

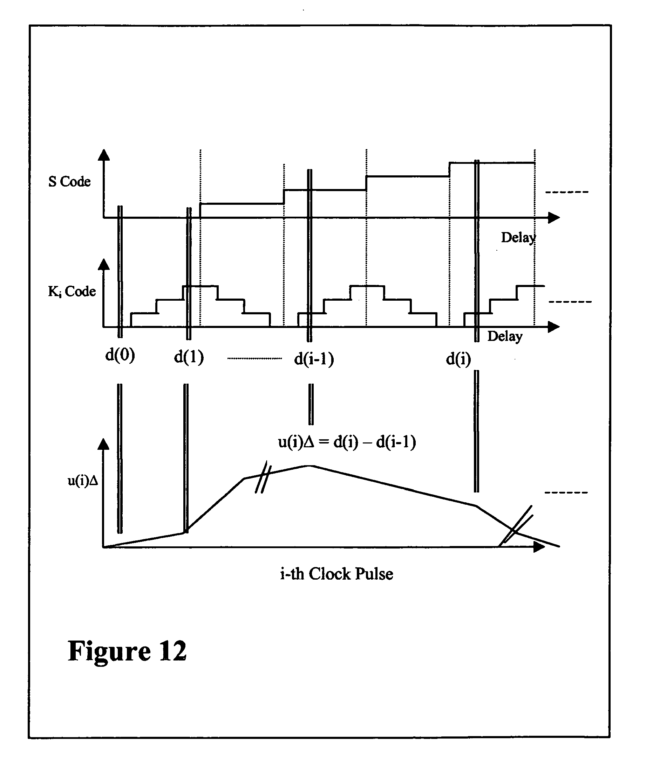

Figure 12 shows an example of arbitrary delay variation using the second embodiment of the invention, to achieve a smooth modulation of clock period. The code for multiplexer selection (i.e., S) is shown as a monotonically increasing code (Y-axis) for increasing delay (X-axis) between Ckin to CKout, whereas, the code for delay interpolation (i.e., $K_i$, Y-axis) is shown as increasing or decreasing for alternate codes of S, for increasing delay (X-axis). The delay variation pattern $u(i).\Delta$ for the i-th clock pulse is determined by the difference of the delay between Ckin to Ckout in a previous clock pulse [d(i-1)], to the same delay during the present clock pulse [d(i)]. Discrete values of S and Ki are generated sequentially corresponding to required d(i)'s for smooth time period modulation as shown in figure 12. This is a more suitable strategy for systems where the percentage variation of clock period is small, yet there is a need to modulate over a larger number of clock cycles to achieve better attenuation in accordance with equation (8). A suitable delay is added before the clock to the control signal generator to avoid glitches.

It will be apparent to those with ordinary skill in the art that the foregoing is merely illustrative intended to be exhaustive or limiting, having been presented by way of example only and that various modifications can be made within the scope of the above invention.

Accordingly, this invention is not to be considered limited to the specific examples chosen for purposes of disclosure, but rather to cover all changes and modifications, which do not constitute departures from the permissible scope of the present invention. The invention is therefore not limited by the description contained herein or by the drawings, but only by the claims.

**Claims**

1. A digital clock modulator providing a smoothly modulated clock period to reduce emitted Electro-Magnetic Radiation (EMR) comprising:

   - a plurality of delay elements (14) connected in series receiving an unmodulated clock signal at the input;
   - a multiplexer (11) receiving inputs from unequally spaced selected taps provided between said delay elements;
   - a control block (12) supplying the selection-inputs to said multiplexer, and receiving a clock signal from said series of delay elements; and
   - a predetermined delay element (13) connected between the clock terminal of said control block and the last element of said series of delay elements for enabling glitch free operation by ensuring that the entire delay chain and related signal paths are in the same stable state before the control to the multiplexer changes.

2. A digital clock modulator as claimed in claim 1 wherein said taps are provided in accordance with the modulation of the clock period.

3. An improved digital clock modulator as claimed in claim 1 wherein said control block includes an up/down counting means for sequentially selecting the taps in the delay chain so that the difference in delays of input to output clock increases consecutively for consecutive clock cycles for one half of the modulating period and then reduces in a similar manner for the second half of the modulating period;

4. A digital clock modulator as claimed in claim 1 wherein the taps are spaced further apart from each other in the middle of the clock chain are spaced closer together at the two ends of the chain.

5. A digital clock modulator as claimed in claim 1 wherein said predetermined delay is determined as

$$\underbrace{\sum u(i).\Delta} + \mathbf{T}_{mux} + T_{del} + T_{CK \to Sel} < \mathbf{T}_{HLmin}$$

   where,
   $T_{mux}$ is the maximum input to output delay of the said multiplexer;
   $\mathbf{T}_{CK \to SEL}$ is the clock to output delay of the said control block;
   $T_{HLmin}$ is the minimum of high or low phase of the said un-modulated clock cycle;
   $T_{del}$ is delay to be provided
   $\Sigma u(i).\Delta$ is the total delay of the said series of delay elements.

6. A digital clock modulator as claimed in claim 1 further including a delay interpolation mechanism for providing a finer resolution of clock modulation over a larger number of clock cycles.

7. A digital clock modulator as claimed in claim 6 wherein the delay interpolation mechanism comprises:

   - a pair of multiplexers replacing the single multiplexer with alternate taps of the delay chain connected to each multiplexer;
   - a chain of series connected PMOS-NMOS transistors pairs that are sized such that their channel-length-to-channel-width ratios increase in a binary weighted sequence, connected to the output of each multiplexer. and
   - a control circuit that generates complementary control signals for enabling the series connected PMOS-NMOS transistor pairs in a desired sequence.

8. A digital clock modulator as claimed in claim 7 wherein the code for multiplexer selection is a monotonically increasing code for increasing clock modulation depth, whereas the code for delay interpolation increases or decreases for alternate codes for the multiplexer

9. A digital clock modulator as claimed in claim 8 wherein the modulating wave form is selected by sequencing the delay selection code and the delay interpolator code to provide consecutively increasing delays and difference in delays in the clock path for consecutive clock cycles over one half of modulating period followed by similarly decreasing delays and difference in delays_for the second half of the modulating period.

**10.** A method for reducing emitted Electro Magnetic Radiation (EMR) from digital clock circuits by smoothly modulating the clock period comprising the steps of:

- connecting a plurality of delay elements in series and supplying an unmodulated clock signal at the input of the first delay element;
- multiplexing selected outputs obtained from selected taps in the chain of delay elements; and
- delaying the clock to the last element of the delay chain suitably with respect to the multiplexing for enabling glitch free operation.

**11.** A method for reducing emitted Electro Magnetic Radiation (EMR) from digital circuits as claimed in claim 10 wherein the taps for multiplexing are selected based on the desired modulating wave.

**12.** A method for reducing emitted Electro Magnetic Radiation (EMR) from digital circuits as claimed in claim 10 including selecting the consecutively increasing delays and difference in delays in the clock delay path in consecutive clock cycles upto a maximum allowed delay, for one half of the modulating wave's period, and then reducing the delays similarly for the second half of the modulating period.

**13.** A method for reducing emitted Electro Magnetic Radiation (EMR) from digital circuits as claimed in claim 10 further including suitably delaying the clock of said control block to ensure that the entire delay chain and other concerned signal paths are in the same stable logical state ('0' or '1') before the control to the multiplexer changes.

**14.** A method for reducing emitted Electro Magnetic Radiation (EMR) from digital circuits as claimed in claim 13 wherein said suitable delay is determined for an unmodulated clock as:

$$\underbrace{\sum u(i).\Delta} + T_{mux} + T_{del} + T_{CK->Sel} < T_{HLmin}$$

where,
$T_{mux}$ is the maximum input to output delay of the said multiplexer;
$T_{K->SEL}$ is the clock to output delay of the said control block;
$T_{HLmin}$ is the minimum of the high or low phase of the said un-modulated clock cycle;
$T_{del}$ is the delay to be provided,
$\Sigma u(i).\Delta$ is the total delay of the said series of delay elements.

**15.** A method for reducing emitted Electro Magnetic Radiation (EMR) from digital circuits as claimed in claim 10 further including a method for delay interpolation for providing a finer resolution of clock modulation.

**16.** A method for reducing emitted Electro Magnetic Radiation (EMR) from digital circuits as claimed in claim 15 wherein the method for delay interpolation comprising the steps of:

- multiplexing alternate taps of the delay chain separately to;
- connecting a chain of series PMOS-NMOS transistors pairs that are sized such that their channel-length-to-channel-width ratios increase in a binary weighted sequence, and
- generating complementary control signals for enabling the series connected PMOS-NMOS transistor pairs in a desired sequence.

**17.** A method for reducing emitted Electro Magnetic Radiation (EMR) from digital circuits as claimed in claim 16 by monotonically increasing the code for multiplexer selection for increasing clock modulation depth and increasing or decreasing the code for delay interpolation for alternate codes for the multiplexer.

**Patentansprüche**

**1.** Digitaltaktmodulator, der eine glatt modulierte Taktperiode schafft, um emittierte elektromagnetische Strahlung (EMR von englisch 'Electro-Magnetic Radiation') zu reduzieren, aufweisend:

- eine Mehrzahl von in Reihe geschalteten Verzögerungselementen (14), die am Eingang ein unmoduliertes Taktsignal empfangen;
- einen Multiplexer (11), der Eingaben von ausgewählten zwischen den Verzögerungselementen vorgesehen ungleichmäßig beabstandeten Tap-Abgriffen empfängt;
- einen Steuerblock (12), der die Auswahleingaben dem Multiplexer zuführt und ein Taktsignal von der Reihe von Verzögerungselementen empfängt; und
- ein zwischen den Taktanschluss des Steuerblocks und das letzte Element der Reihe von Verzögerungselementen geschaltetes Verzögerungselement (13) für das Ermöglichen einer störungsfreien Operation durch das Sicherstellen, dass die gesamte Verzögerungskette und damit in Verbindung stehende Signalpfade im gleichen stabilen Zustand sind, bevor sich die Steuerung zu dem Multiplexer ändert.

2. Digitaltaktmodulator nach Anspruch 1, wobei die Tap-Abgriffe entsprechend der Modulation der Taktperiode vorgesehen sind.

3. Verbesserter Digitaltaktmodulator nach Anspruch 1, wobei der Steuerblock eine Hoch/Runter-Zähleinrichtung für das sequentielle Auswählen der Tap-Abgriffe in der Verzögerungskette aufweist, so dass der Unterschied in Verzögerungen vom Eingangstakt zum Ausgangstakt für aufeinander folgende Taktzyklen für eine Hälfte der Modulationsperiode fortlaufend zunimmt und dann für die zweite Hälfte der Modulationsperiode auf eine ähnliche Weise abnimmt;

4. Digitaltaktmodulator nach Anspruch 1, wobei die Abstände zwischen den Tap-Abgriffen in der Mitte der Taktkette größer sind und an den zwei Enden der Kette kleiner sind.

5. Digitaltaktmodulator nach Anspruch 1, wobei die vorherbestimmte Verzögerung bestimmt ist als

$$\underbrace{\sum u(i).\Delta} + T_{mux} + T_{del} + T_{CK\text{-}>Sel} < T_{HLmin},$$

wobei
$T_{mux}$ die maximale Eingabe-zu-Ausgabeverzögerung des Multiplexers ist;
$T_{CK\text{-}>Sel}$ die Takt-zu-Ausgabe-Verzögerung des Steuerblocks ist;
$T_{HLmin}$ das Minimum der hohen oder niedrigen Phase des unmodulierten Taktzyklus ist;
$T_{del}$ die zu schaffende Verzögerung ist und
$\sum u(i).\Delta$ die Gesamtverzögerung der Reihe von Verzögerungselementen ist.

6. Digitaltaktmodulator nach Anspruch 1, ferner aufweisend einen Verzögerungsinterpolationsmechanismus für das Schaffen einer besseren Auflösung von Taktmodulation über eine größere Anzahl von Taktzyklen.

7. Digitaltaktmodulator nach Anspruch 6, wobei der Verzögerungsinterpolationsmechanismus aufweist:

ein Paar Multiplexer, die den einzelnen Multiplexer ersetzen, wobei wechselnde Tap-Abgriffe der Verzögerungskette mit jedem Multiplexer verbunden sind;
eine Kette von in Reihe geschalteten PMOS-NMOS-Transistor-Paaren, die so bemessen sind, dass ihre Kanallänge-zu-Kanalbreite-Verhältnisse in einer binär gewichteten Folge zunehmen, und die mit dem Ausgang von jedem Multiplexer verbunden sind, und
eine Steuerschaltung, die komplementäre Steuersignale für das Freigeben der in Reihe geschalteten PMOS-NMOS-Transistor-Paare in einer erwünschten Folge erzeugt.

8. Digitaltaktmodulator nach Anspruch 7, wobei der Code für die Multiplexerauswahl ein monoton zunehmender Code für das Zunehmen der Taktmodulationstiefe ist, während der Code für die Verzögerungsinterpolation für wechselnde Codes für den Multiplexer zunimmt oder abnimmt

9. Digitaltaktmodulator nach Anspruch 8, wobei die Modulationswellenform durch die Reihenfolgebildung des Verzögerungsauswahlcodes und des Verzögerungsinterpolatorcodes gewählt wird, um ein fortlaufendes Zunehmend der Verzögerungen und des Unterschieds in den Verzögerungen in dem Taktpfad für aufeinander folgende Taktzyklen über eine Hälfte der Modulationsperiode gefolgt von einem ähnlichen Abnehmen der Verzögerungen und des Unterschieds in den Verzögerungen für die zweite Hälfte der Modulationsperiode zu schaffen.

10. Verfahren für das Reduzieren von emittierter elektromagnetischer Strahlung (EMR) von Digitaltaktschaltungen durch das glatte Modulieren der Taktperiode, aufweisend folgende Schritte:

in Reihe Schalten einer Mehrzahl von Verzögerungselementen und Zuführen eines unmodulierten Taktsignals zu dem Eingang des ersten Verzögerungselements;
Multiplexen von ausgewählten Ausgaben, die von ausgewählten Tap-Abgriffen in der Kette von Verzögerungselementen erhalten werden; und
Verzögern des Taktsignals zu dem letzten Element der Verzögerungskette auf eine hinsichtlich des Multiplexens geeignete Weise für das Ermöglichen einer störungsfreien Operation.

11. Verfahren für das Reduzieren von emittierter elektromagnetischer Strahlung (EMR) von Digitalschaltungen nach Anspruch 10, wobei die Tap-Abgriffe für das Multiplexen auf der Basis der erwünschten Modulationswelle ausgewählt werden.

12. Verfahren für das Reduzieren von emittierter elektromagnetischer Strahlung (EMR) von Digitalschaltungen nach Anspruch 10, aufweisend das Auswählen des fortlaufenden Zunehmens der Verzögerungen und des Unterschieds in den Verzögerungen in dem Taktverzögerungspfad in aufeinander folgenden Taktzyklen bis zu einer zugelassen Maximalverzögerung für eine Hälfte der Modulationswellenperiode und dann das ähnliche Reduzieren der Verzögerungen für die zweite Hälfte der Modulationsperiode.

13. Verfahren für das Reduzieren von emittierter elektromagnetischer Strahlung (EMR) von Digitalschaltungen nach Anspruch 10, ferner aufweisend ein geeignetes Verzögern des Taktsignals des Steuerblocks, um sicherzustellen, dass die gesamte Verzögerungskette und andere betroffene Signalpfade in dem gleichen stabilen Logikzustand sind ('0' oder '1'), bevor sich die Steuerung zu dem Multiplexer ändert.

14. Verfahren für das Reduzieren von emittierter elektromagnetischer Strahlung (EMR) von Digitalschaltungen nach Anspruch 13, wobei die geeignete Verzögerung für ein unmoduliertes Taktsignal wie folgend bestimmt ist:

$$\sum u(i) . \Delta + T_{mux} + T_{del} + T_{CK->Sel} < T_{HLmin},$$

wobei
$T_{mux}$ die maximale Eingabe-zu-Ausgabeverzögerung des Multiplexers ist;
$T_{CK->Sel}$ die Takt-zu-Ausgabe-Verzögerung des Steuerblocks ist;
$T_{HLmin}$ das Minimum einer hohen oder niedrigen Phase des unmodulierten Taktzyklus ist;
$T_{del}$ die zu schaffende Verzögerung ist und
$\sum u(i) . \Delta$ die Gesamtverzögerung der Reihe von Verzögerungselementen ist.

15. Verfahren für das Reduzieren von emittierter elektromagnetischer Strahlung (EMR) von Digitalschaltungen nach Anspruch 10, ferner aufweisend ein Verfahren für Verzögerungsinterpolation für das Schaffen einer besseren Auflösung von Taktmodulation.

16. Verfahren für das Reduzieren von emittierter elektromagnetischer Strahlung (EMR) von Digitalschaltungen nach Anspruch 15, wobei das Verfahren für Verzögerungsinterpolation folgende Schritte aufweist:

getrenntes Multiplexen von wechselnden Tap-Abgriffen der Verzögerungskette;
Verbinden einer Kette von Reihen-PMOS-NMOS-Transistor-Paaren, die so bemessen sind, dass ihre Kanallänge-zu-Kanalbreite-Verhältnisse in einer binär gewichteten Folge zunehmen, und
Erzeugen von komplementären Steuersignalen für das Aktivieren der in Reihe geschalteten PMOS-NMOS-Transistor-Paaren in einer erwünschten Folge.

17. Verfahren für das Reduzieren von emittierter elektromagnetischer Strahlung (EMR) von Digitalschaltungen nach Anspruch 16 durch das monotone Erhöhen des Codes für die Multiplexerauswahl für das Zunehmen der Taktmodulationstiefe und das Erhöhen oder Verringern des Codes für Verzögerungsinterpolation für wechselnde Codes für den Multiplexer.

**Revendications**

1. Modulateur numérique d'horloge pour fournir une période d'horloge modulée de façon douce pour réduire le rayonnement électromagnétique (EMR) émis, comprenant :

   une pluralité d'éléments de retard (14) connectés en série recevant un signal d'horloge non modulé en entrée ;
   un multiplexeur (11) recevant des entrées de prises sélectionnées espacées de façon inégale prévues entre les d'éléments de retard ;
   un bloc de commande (12) fournissant les entrées de sélection au multiplexeur et recevant un signal d'horloge à partir de la succession d'éléments de retard ; et
   un élément de retard prédéterminé (13) connecté entre la borne d'horloge du bloc de commande et le dernier élément de la succession d'éléments de retard pour permettre un fonctionnement exempt d'impulsions parasites en assurant que toute la chaîne de retard et les trajets de signal associé sont dans le même état stable avant que la commande du multiplexeur change.

2. Modulateur numérique d'horloge selon la revendication 1, dans lequel les prises sont prévues en accord avec la modulation de la période d'horloge.

3. Modulateur numérique d'horloge selon la revendication 1, dans lequel le bloc de commande comprend un moyen de compteur/décompteur pour sélectionner séquentiellement les prises dans la chaîne de retard de sorte que la différence de retards de l'entrée à l'horloge de sortie augmente successivement pour des cycles d'horloge successifs pendant une moitié de la période de modulation puis se réduit de façon similaire dans la seconde moitié de la période de modulation.

4. Modulateur numérique d'horloge selon la revendication 1, dans lequel les prises sont davantage espacées au milieu de la chaîne d'horloge et sont moins espacées aux deux extrémités de la chaîne d'horloge.

5. Modulateur numérique d'horloge selon la revendication 1, dans lequel le retard prédéterminé est déterminé comme suit :

$$\sum_{14}u(i)_{\frac{1}{2}13}\Delta + T_{mux} + T_{del} + T_{CK->Sel} < T_{HL\,min}$$

où :

   $T_{mux}$ est le retard maximum entre entrée et sortie du multiplexeur ;
   $T_{CK->SEL}$ est le retard de l'horloge à la sortie du bloc de commande ;
   $T_{HLmin}$ est le minimum de phase haute ou basse du cycle d'horloge non modulé ;
   $T_{del}$ est le retard à fournir ;
   $\sum u(i).\Delta$ est le retard total de la succession d'éléments de retard.

6. Modulateur numérique d'horloge selon la revendication 1, comprenant en outre un mécanisme d'interpolation de retard pour fournir une réduction plus fine de modulation d'horloge sur un plus grand nombre de cycles d'horloge.

7. Modulateur numérique d'horloge selon la revendication 6, dans lequel le mécanisme d'interpolation de retard comprend :

   deux multiplexeurs remplaçant le multiplexeur unique, des prises alternées de la chaîne de retard étant connectées à chaque multiplexeur ;
   une succession de paires de transistors PMOS-NMOS connectés en série dimensionnés de sorte que le rapport entre la longueur de canal et la largeur de canal augmente selon une séquence pondérée binaire, connectés à la sortie de chaque multiplexeur et
   un circuit de commande qui produit des signaux de commande complémentaire pour valider les paires de transistors PMOS-NMOS connectés en série selon une séquence désirée.

**8.** Modulateur numérique d'horloge selon la revendication 7, dans lequel le code de sélection de multiplexeur est un code croissant de façon monotome pour augmenter la profondeur de modulation d'horloge, tandis que le code d'interpolation de retard augmente ou diminue pour des codes alternés du multiplexeur.

**9.** Modulateur numérique d'horloge selon la revendication 8, dans lequel la forme d'onde de modulation est choisie en séquençant le code de sélection de retard et le code d'interpolateur de retard pour fournir des retards et une différence entre retards dans le trajet d'horloge augmentant successivement pour des cycles d'horloge successifs sur une moitié de la période de modulation suivie de retards et de différences de retard décroissant de façon similaire pendant la seconde moitié de la période de modulation.

**10.** Procédé de réduction du rayonnement électromagnétique (EMR) émis à partir de circuits d'horloge numériques en modulant de façon douce la période d'horloge comprenant les étapes suivantes :

connecter une pluralité d'éléments de retard en série et fournir un signal d'horloge non modulé à l'entrée du premier élément de retard ;
multiplexeur des sorties sélectionnées obtenues à partir de prises sélectionnées dans la succession d'éléments de retard ; et
retarder l'horloge du dernier élément de la chaîne de retard de façon appropriée par rapport au multiplexage pour permettre un fonctionnement exempt d'impulsions.

**11.** Procédé de réduction du rayonnement électromagnétique (EMR) émis à partir de circuits numériques selon la revendication 10, dans lequel les prises pour le multiplexage sont sélectionnées en fonction de l'onde de modulation désirée.

**12.** Procédé de réduction du rayonnement électromagnétique (EMR) émis à partir de circuits numériques selon la revendication 10, incluant la sélection de retards et de différence entre retard croissant successivement dans le trajet de retard d'horloge lors de cycles successifs jusqu'à un retard maximum permis, pendant une moitié de la période d'onde de la modulation, puis des retards et des différences entre retard décroissant de façon similaire pendant la seconde moitié de la période de modulation.

**13.** Procédé de réduction du rayonnement électromagnétique (EMR) émis à partir de circuits numériques selon la revendication 10, comprenant en outre un retard approprié de l'horloge du bloc de commande pour assurer que toute la chaîne de retard et d'autres trajets de signal concerné sont dans le même état logique stable ('0' ou '1') avant que la commande vers le multiplexeur ne change.

**14.** Procédé de réduction du rayonnement électromagnétique (EMR) émis à partir de circuits numériques selon la revendication 13, dans lequel le retard approprié est déterminé pour une horloge non modulée comme suit :

$$\sum_{i=2}^{43} u(i)_{43} \Delta + T_{mux} + T_{del} + T_{CK->Sel} < T_{HL\,min}$$

où :

$T_{mux}$ est le retard maximum entre entrée et sortie du multiplexeur ;
$T_{CK->SEL}$ est le retard de l'horloge de la sortie du bloc de commande ;
$T_{HLmin}$ est le minimum de phase haute ou basse du cycle d'horloge non modulé ;
$T_{del}$ est le retard à fournir ;
$\Sigma u(i).\Delta$ est le retard total de la succession d'éléments de retard.

**15.** Procédé de réduction du rayonnement électromagnétique (EMR) émis à partir de circuits numériques selon la revendication 10, comprenant en outre un procédé pour une interpolation de retard pour fournir une résolution plus fine de la modulation d'horloge.

**16.** Procédé de réduction du rayonnement électromagnétique (EMR) émis à partir de circuits numériques selon la revendication 15, dans lequel le procédé d'interpolation de retard comprend les étapes suivantes :

multiplexer des prises alternées de la chaîne de retard séparément ;
connecter une chaîne de paires de transistors PMOS-NMOS en série qui sont dimensionnés de sorte que leurs rapports entre longueur de canal et largeur de canal augmente sur une séquence binaire pondérée ; et
produire des signaux de commande complémentaires pour valider la succession de paires de transistors PMOS-NMOS connectés en série selon une séquence désirée.

17. Procédé de réduction du rayonnement électromagnétique (EMR) émis à partir de circuits numériques selon la revendication 16, en augmentant de façon monotone le code de sélection d'un multiplexeur pour augmenter la profondeur de modulation de l'horloge et augmenter ou diminuer le code d'interpolation de retard pour des codes alternés pour le multiplexeur.

**Figure 1**

**Figure 2**

**Figure 3**

**Figure 4**

**Figure 5**

**Figure 6**

**Figure 7**

**Figure 8**

**Figure 9**

**Figure 10**

Figure 11

**Figure 12**

## REFERENCES CITED IN THE DESCRIPTION

### Patent documents cited in the description

- US 6366174 B
- US 6373306 B
- US 6351485 B1
- US 5442664 A
- US 6518813 B
- US 2001045857 A
- US 5699005 A
- US 6169436 B

### Non-patent literature cited in the description

- **KEITH B. HARDIN et al.** Spread Spectrum Clock Generation for the Reduction of Radiated Emissions. *IEEE International Symposium on Electromagnetic Compatibility,* 22 August 1994